# EUROPÄISCHE PATENTSCHRIFT

(11) **EP 3 485 509 B1**
(45) Veröffentlichungstag und Bekanntmachung des Hinweises auf die Patenterteilung: **25.03.2020**
(21) Anmeldenummer: 17768102.0
(22) Anmeldetag: 14.09.2017
(51) Int. Cl.: H01L 23/427

(54) **SCHALTSCHRANK MIT EINEM GESCHLOSSENEN GEHÄUSE UND EINER KÜHLVORRICHTUNG**
COOLING DEVICE FOR COOLING ELECTRIC AND/OR ELECTRONIC DEVICES ARRANGED WITHIN A CLOSED HOUSING
DISPOSITIF DE REFROIDISSEMENT POUR DES ÉQUIPEMENTS ÉLECTRONIQUES OU ÉLECTRIQUES DISPOSÉS À L'INTÉRIEUR D'UN BOÎTIER FERMÉ

(30) Priorität: 20.10.2016 EP 16194702
(43) Veröffentlichungstag der Anmeldung: 22.05.2019
(73) Patentinhaber: Siemens Aktiengesellschaft, 80333 München (DE)
(72) Erfinder: KNAUER, Hans, 91359 Leutenbach (DE)
(86) Internationale Anmeldenummer: PCT/EP2017/073076
(87) Internationale Veröffentlichungsnummer: WO 2018/072932

(56) Entgegenhaltungen:
- WO-A1-2008/108777
- DE-U1-202012 008 740
- US-A1- 2005 217 829
- US-A1- 2014 090 814

## Beschreibung

Die vorliegende Erfindung betrifft einen Schaltschrank mit einem geschlossenen Gehäuse und einer Kühlvorrichtung zum Kühlen von im Innern des Gehäuses anordenbaren elektrischen und/oder elektronischen Betriebsmitteln.

Elektrische und elektronische Komponenten einer verfahrenstechnischen Anlage, einer Werkzeugmaschine oder Fertigungseinrichtung, die sich nicht direkt in der Maschine befinden (z. B. Sensoren), sind aus mehreren Gründen in einem eigenen Gehäuse untergebracht. Das Gehäuse soll für die Komponenten in seinem Innenraum unter anderem Schutz vor Staub und Wasser bieten, es soll weiterhin der Halterung und Strukturierung des inneren Aufbaus dienen und es soll die in seinem Innenraum angeordneten Betriebsmittel vor Überhitzung schützen, usw.

Jedoch sind bei Gehäusekonstruktionen für hohe Schutzarten, beispielsweise für Schutzklasse IP 54 oder Schutzklasse IP 65, oder für Anwendungen im Freien, besondere Maßnahmen zur Entwärmung der im Gehäuse angeordneten Betriebsmittel erforderlich.

So sind bei luftgekühlten Gehäusen für hohe Schutzarten Filtereinrichtungen für die Kühlluft vorgesehen, wie beispielsweise in der Luftströmung angeordnete Filtermatten. Damit kann Schutz bis Schutzklasse IP 54 erreicht werden. Nachteilig ist dabei jedoch, dass die Filter regelmäßig gereinigt oder getauscht werden müssen.

Für Anwendungen im Freien findet auch eine so genannte Durchsteckkühlung Verwendung, bei der Betriebsmittel mit hoher Verlustleistung, wie beispielsweise Halbleiterleistungsmodule, direkt mit der Umgebungsluft gekühlt werden. Die Durchsteckkühlung umfasst einen in einer Wandung des Gehäuses angeordneten Kühlkörper. Auf dem Kühlkörper ist innerhalb des Gehäuses das Betriebsmittel montiert, die Kühlrippen des Kühlkörpers sind außerhalb des Gehäuses angeordnet. Dabei muss der Kühlkörper für "unreine" Luft dimensioniert werden, was größere Kühlrippenabstände und somit eine entsprechend große Dimensionierung des Kühlkörpers erforderlich macht. Zudem kann die Reinigung des Kühlkörpers je nach Einbauort und Umgebung des Gehäuses schwierig sein. Die Betriebswärme der übrigen im Gehäuse angeordneten Betriebsmittel muss dann zusätzlich beispielsweise über eine Luftkühlung mit im Luftstrom angeordneten Filtermatten abgeführt werden.

Hohe Verlustleistungen der im Gehäuse angeordneten Betriebsmittel können auch über eine Flüssigkeitskühlung abgeführt werden. Ein Flüssigkeitskühlkreislauf, beispielsweise ein Wasserkreislauf, zur Kühlung ist jedoch nur bei wenigen Anwendungen vorhanden.

Schließlich werden zur Kühlung der im Gehäuse angeordneten Betriebsmittel Klimageräte eingesetzt. Klimageräte müssen jedoch gewartet werden, beispielsweise zum Tausch der Filter, und erfordern zum Betrieb zusätzliche Energie.

In der US-Patentanmeldungsveröffentlichung US 2005/0217829 A1 ist eine flach gebaute Kühlvorrichtung für Computer oder andere elektronische Geräte beschrieben, die nach dem Thermosiphon-Prinzip arbeitet. Die Thermosiphon-Kühlvorrichtung ist mit einer zu kühlenden Wärmequelle, typischerweise eine CPU (Central Processing Unit), in einem Computergehäuse angeordnet und umfasst einen auf der Wärmequelle platzierten Verdampfer und einen horizontal daneben angeordneten Kondensor. Der Kondensor umfasst Kühlrippen, die die Wärme an einen Luftstrom abgeben. Der Luftstrom kann, nachdem er die Kühlrippen passiert hat, über Abzugsöffnungen das Gehäuse verlassen.

In der US-Patentanmeldungsveröffentlichung US 2014/0090814 A1 ist eine Thermosiphon-Kühlvorrichtung für ein elektronisches Gerät beschrieben. In der Anwendung ist die Thermosiphon-Kühlvorrichtung mit den zu kühlenden Halbleiterbauteilen, dort CPUs, und mit weiteren Bauteilen in ein Servergehäuse eingebaut. Ein zur Thermosiphon-Kühlvorrichtung gehörender Kondensor ist innerhalb des Servergehäuses in einem Luftkanal derart angeordnet, dass er mittels Ventilatoren mit Kühlluft von außen versorgt werden kann.

Die PCT-Veröffentlichung WO 2008/108777 A1 offenbart ebenfalls ein flach gebautes Thermosiphon-Kühlsystem für ein elektronisches Gerät, das zusammen mit den wärmeerzeugenden Bauteilen in einem Gehäuse eingebaut ist. In dem Gehäuse sind an zwei gegenüberliegenden Flachseiten Löcher eingebracht. Ventilatoren erzeugen einen Luftstrom, der die von den Bauteilen erzeugte aus dem Gehäuse abführt.

In der DE-Gebrauchsmusterschrift DE 20 2012 008 740 U1 ist ein Kühlsystem für Leistungselektronik-Umrichter mit einem Primärkühlstrom zum Kühlen eines Sekundärkühlkreislaufes über Wärmetauscher beschrieben. Der Sekundärkühlkreislauf ist wärmeleitend mit Leistungselektronik-Bauelementen verbunden und als Thermosiphon-Kühlkreislauf ausgebildet. Die Wärmetauscher sind zumindest teilweise redundant, so dass sie ohne Betriebsunterbruch gegen einen anderen Wärmetauscher vom gleichen Typ austauschbar sind.

Die Aufgabe der vorliegenden Erfindung besteht darin, einen Schaltschrank mit einem geschlossenen Gehäuse und einer robusten und wartungsarmen Kühlvorrichtung zum Kühlen von in dem Gehäuse anordenbaren elektrischen und/oder elektronischen Betriebsmitteln anzugeben.

Die Aufgabe wird durch einen Schaltschrank mit einem geschlossenen Gehäuse und einer Kühlvorrichtung mit den Merkmalen des Patentanspruchs 1 gelöst. Danach umfasst der eingangs genannte Schaltschrank einen ersten geschlossenen Kühlkreislauf, der ein erstes Kühlmedium enthält zum Abtransport von Wärme, die im Betrieb von mindestens einem der Betriebsmittel erzeugt wird, aus dem Gehäuse heraus, wobei der erste Kühlkreislauf innerhalb des Gehäuses mit einem ersten Wärmeübertrager zum Übertragen der Wärme von dem mindestens einen Betriebsmittel auf das erste Kühlmedium und außerhalb des Gehäuses mit einem zweiten Wärmeübertrager zum Abgeben der Wärme an ein Außenkühlmedium verbunden ist, wobei der zweite Wärmeübertrager oberhalb des ersten Wärmeübertragers angeordnet ist, wobei der erste Kühlkreislauf, das erste Kühlmedium und der erste und zweite Wärmeübertrager ausgebildet sind, den Wärmetransport nach dem Zweiphasen-Thermosiphon-Prinzip zu realisieren, und wobei der Kühlkreislauf Leitungen für das erste Kühlmedium umfasst, die über Durchführungen abgedichtet aus dem Gehäuse geführt sind und den ersten Wärmeübertrager und den zweiten Wärmeübertrager miteinander verbinden.

Der Wärmetransport nach dem Zweiphasen-Thermosiphon-Prinzip erlaubt durch die Nutzung der Verdampfungswärme des Kühlmediums eine hohe Wärmestromdichte. Über eine kleine Querschnittsfläche können so große Verlust-Wärmemengen transportiert werden. Der Transport des Kühlmediums erfolgt generell passiv, d.h. ohne Hilfsmittel wie etwa eine Umwälzpumpe. Das Kühlmittel kreist lediglich aufgrund der Schwerkraft im Kühlkreislauf, wodurch sich eine niedrige Energiebilanz für die Kühlung ergibt. Somit kann die Kühlvorrichtung hohe Verlustleistungen bei einem wartungsarmen Aufbau abführen. Da mit diesem Kühlkonzept außer Rohrdurchführungen im Gehäuse keine weiteren Öffnungen für den Kühlkreislauf notwendig sind, können hohe IP-Schutzarten, wie beispielsweise IP 65, einfach realisiert werden.

Eine vorteilhafte Ausgestaltung der Kühlvorrichtung ist durch die Merkmale des Anspruchs 2 gegeben. Danach ist der erste Wärmeübertrager als Kühlkörper ausgebildet zur wärmeleitenden Verbindung mit dem mindestens einen der Betriebsmittel. Der Wärmetransport von dem Betriebsmittel zum Kühlmedium erfolgt direkt durch Wärmeleitung über den Kühlkörper. Das Kühlmedium nimmt an der Oberfläche des Kühlkörpers die transportierte Wärme auf und verdampft dadurch.

Eine weitere vorteilhafte Ausgestaltung der Kühlvorrichtung ist durch die Merkmale des Anspruchs 3 gegeben. Danach ist der erste Wärmeübertrager zur Montage mindestens eines Leistungshalbleiters ausgebildet. Anwendung findet diese Ausgestaltung der Kühlvorrichtung bei Umrichterschränken mit hohen abzuführenden Verlustleistungen.

Eine besonders vorteilhafte Ausgestaltung der Kühlvorrichtung ist durch die Merkmale des Anspruchs 6 gegeben. Danach umfasst die Kühlvorrichtung einen zweiten geschlossenen Kühlkreislauf zum Kühlen von mindestens einem weiteren, im Innern des geschlossenen Gehäuses angeordneten elektrischen und/oder elektronischen Betriebsmittel, der ein zweites Kühlmedium enthält zum Abtransport von Wärme, die im Betrieb von dem mindestens einem weiteren der Betriebsmittel erzeugt wird, aus dem Gehäuse heraus, wobei der zweite Kühlkreislauf innerhalb des Gehäuses mit einem dritten Wärmeübertrager zum Übertragen der Wärme von dem mindestens einen weiteren Bauteil auf das zweite Kühlmedium und außerhalb des Gehäuses mit einem vierten Wärmeübertrager zum Abgeben der Wärme an das Außenkühlmedium verbunden ist, wobei der vierte Wärmeübertrager oberhalb des dritten Wärmeübertragers angeordnet ist und der zweite Kühlkreislauf, das zweite Kühlmedium und der dritte und vierte Wärmeübertrager ausgebildet sind, den Wärmetransport nach dem Zweiphasen-Thermosiphon-Prinzip zu realisieren. Der zweite Kühlkreislauf dient zum Kühlen von internen Betriebsmitteln, die im Betrieb andere thermische Randbedingungen einhalten müssen, als die Betriebsmittel, die über den ersten Kühlkreislauf entwärmt werden.

Eine weitere, besonders vorteilhafte Ausgestaltung der Kühlvorrichtung ist durch die Merkmale des Anspruchs 7 gegeben. Danach ist der dritte Wärmeübertrager ausgebildet, die mittels einer Luftströmung von dem mindestens einem weiteren Betriebsmittel zum dritten Wärmeübertrager transportierte Wärme an das zweite Kühlmedium zu übertragen. Insbesondere bei Betriebsmitteln mit nur geringen Verlustleistungen kann die im Betrieb erzeugte Wärme über die an deren Oberflächen vorbei streichende Luftströmung abgeführt werden. Damit ist ein besonders einfacher Aufbau des zweiten Kühlkreislaufs möglich.

Eine weitere vorteilhafte Ausgestaltung ist durch die Merkmale des Anspruchs 11 gegeben. Danach ist der dritte Wärmeübertrager mit einer im Gehäuse angeordneten Luftführung verbunden. Dadurch kann der Wärmetransport über die Luftströmung weiter erhöht werden.

Eine weitere besonders vorteilhafte Ausgestaltung ist durch die Merkmale des Anspruchs 12 gegeben. Danach bilden der zweite und vierte Wärmeübertrager eine bauliche Einheit zur Abgabe der transportierten Wärme an ein gemeinsames Kühlmedium. Damit werden alle Verlustleistungen über einen gemeinsamen externen Zweiphasen-Wärmetauscher aus dem geschlossenen Gehäuse abgeführt.

Die vorstehend beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:
- FIG 1: in einer Seitenansicht einen Schaltschrank mit einem geschlossenen Gehäuse mit zwei Kühlkreisläufen,
- FIG 2: der Schaltschrank nach FIG 1 in einer Frontansicht und
- FIG 3: eine Ausführung der externen Zweiphasen-Wärmetauscher mit Wasserkühlung.

Elektrische und elektronische Betriebsmittel oder Komponenten einer verfahrenstechnischen Anlage, einer Werkzeugmaschine oder Fertigungseinrichtung, die sich nicht direkt in der Maschine befinden (z.B. Sensoren), werden in separaten Gehäusen montiert und verschaltet. Dabei soll das Gehäuse den elektrischen und elektronischen Betriebsmitteln in seinem Innenraum Schutz vor Staub und Wasser bieten. Dazu sind die Gehäuse in Schutzarten oder IP-Schutzklassen eingeteilt. Zusätzlich bietet der Innenraum des Gehäuses Halt und Struktur für die Betriebsmittel. Eine geeignete Gehäuseklimatisierung bietet Schutz vor Überhitzung. Die Gehäuse können je nach Anforderung auch noch Schutz vor elektromagnetischer Beeinflussung (EMV), Schutz gegen mechanische Einflüsse, Vandalismus und Erdbeben bieten (beispielsweise durch die Verwendung von Gehäusen mit zusätzlichen Streben) und die Umgebung gegen elektromagnetische Emissionen abschirmen. Auch soll das Gehäuse ggf. Schutz gegen das Berühren gefährlicher Spannungen (Schutzklassen: Schutzerdung oder Schutzisolation) und Brandschutz (Speziallösungen für Entrauchungsanlagen) bieten. Im nachfolgend beschriebenen Ausführungsbeispiel ist der Fokus auf den Schutz der eingebauten Betriebsmittel vor Staub und Wasser sowie der Abführung der im Inneren des Gehäuses erzeugten Verlustwärme gerichtet.

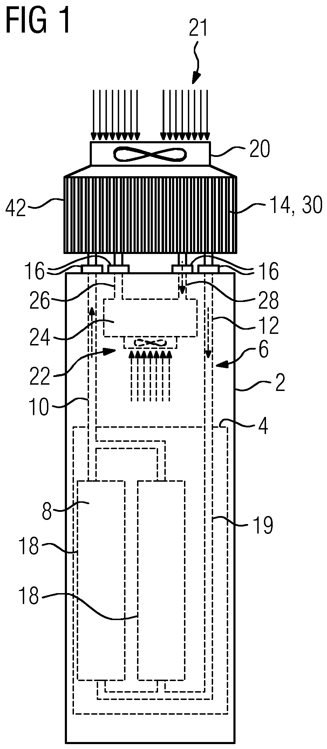

FIG 1 zeigt von der Seite im Schnitt ein geschlossenes Gehäuse 2, in dem elektrische und elektronische Betriebsmittel zur Ansteuerung eines elektrischen Antriebs (hier nicht dargestellt) montiert und elektrisch verschaltet sind. Das geschlossene Gehäuse 2 ist in Form eines Schaltschranks realisiert. Die elektrischen und elektronischen Betriebsmittel sind beispielsweise als Frequenzumrichter für Antriebsleistungen von mehreren 100 kW bis einigen Megawatt ausgebildet und entsprechend dimensioniert.

Damit der Frequenzumrichter (bzw. allgemein die elektrischen und elektronischen Betriebsmittel) auch unter erschwerten Umweltbedingungen über viele Jahre sicher arbeiten kann, ist das Gehäuse 2 gegen das Eindringen von Fremdkörpern und Wasser, auch verschmutztes Wasser, dicht ausgebildet. Die Eignung von elektrischen Betriebsmitteln für verschiedene Umgebungsbedingungen sowie zusätzlich der Schutz von Menschen gegen potentielle Gefährdung bei deren Benutzung wird durch die Schutzart festgelegt. Vorliegend soll das Gehäuse 2 beispielsweise mit einem Schutzgrad für Berührungs- und Fremdkörperschutz mindestens der Kennziffer "5" und mit einem Schutzgrad für Wasserschutz mindestens der Kennziffer "4" ausgebildet sein. Das Gehäuse kann auch ausgebildet sein, um bei Aufstellung im Freien den eingebauten Betriebsmitteln Schutz vor schädlichen Umwelteinflüsse zu bieten. Zur Erreichung derart hoher Schutzarten oder auch für Anwendungen im Freien ist auf den Abtransport der im Betrieb erzeugten Verlustwärme besonderes Augenmerk zu richten, wie nachfolgend noch detaillierter beschrieben ist.

Das Gehäuse 2 enthält ein Leistungshalbleitermodul oder auch Powermodul 4, das im Betrieb besonders hohe Verlustleistungen erzeugt. Zum Abtransport der im Betrieb erzeugten Verlustwärme, beispielsweise in der Größenordnung von 20 kW, ist das Powermodul 4 mit einem ersten geschlossenen Kühlkreislauf 6 verbunden.

Der Kühlkreislauf umfasst einen ersten Wärmeübertrager 8, der über eine Steigleitung 10 und eine Fallleitung 12 mit einem zweiten Wärmeübertrager 14 verbunden ist. Der zweite Wärmeübertrager 14 ist außerhalb des Gehäuses 2 und vertikal oberhalb des ersten Wärmeübertragers 8 angeordnet. Jeweils eine Durchführung 16 dichtet die Steigleitung 10 und die Fallleitung 12 gegenüber dem Gehäuse 2 ab. Der erste Wärmeübertrager 8 umfasst mehrere im Powermodul 4 integrierte Kühlkörper 18, auf denen wärmeleitend Leistungshalbleiter (hier nicht dargestellt) montiert sind. In dem Powermodul 4 sind die Steigleitung 10 und die Fallleitung 12 über integrierte Leitungen 19 mit den Kühlkörpern 18 verbunden.

Der Kühlkreislauf 6 ist mit einem Kühlmittel gefüllt und arbeitet nach dem Zweiphasen-Thermosiphon-Prinzip. Dabei wird die latente Verdampfungshitze des Kühlmittels genutzt, um die im Betrieb erzeugte Verlustwärme von den Kühlkörpern 18 zu dem zweiten Wärmeübertrager 14 zu transportieren. Die Anwendung des Zweiphasen-Thermosiphon-Prinzips erlaubt einen besonders einfachen Aufbau des Kühlkreislaufs 6 bei gleichzeitig hoher Wärmetransportleistung. Da die Temperatur des Kühlmittels bei der Anwendung des Zweiphasen-Thermosiphon-Prinzips nicht über die Verdampfungstemperatur ansteigen kann, können hier übliche Kühlmittel zum Einsatz kommen, die eine derartige Verdampfungstemperatur besitzen, dass im Betrieb die maximal zulässige Halbleitertemperatur nicht überschritten wird. Der Transport des Kühlmittels im Kühlmittelkreislauf 6 erfolgt ausschließlich über Gravitationskräfte, so dass keine zusätzlichen Kühlmittelpumpen für die Umwälzung des Kühlmittels benötigt werden.

Der zweite Wärmeübertrager 14 ist als Zweiphasen-Luft-Wärmetauscher ausgebildet und umfasst einen Ventilator 20 zum forcierten Wärmetransport an die Umgebung über die von dem Ventilator 20 erzeugte Luftströmung. Die Luftströmung durch den Wärmetauscher 14 soll durch Pfeile 21 angegeben werden. Wenn der Wärmetauscher 14 großzügig bezüglich des Wärmetransports dimensioniert ist, kann der Ventilator 20 ohne große Anforderungen hinsichtlich der Druckstabilität und Luftmenge ausgelegt werden. Es können dann beispielsweise Standardventilatoren oder Standardlüfter eingesetzt werden, wie sie auch für die Gebäudeklimatisierung verwendet werden.

In dem Gehäuse 2 ist ein zweiter Kühlkreislauf 22 angeordnet, der die Wärme aus dem Innern des Gehäuses 2 an die Umgebung ebenfalls mittels eines Kühlmittels nach dem Zweiphasen-Thermosiphon-Prinzip transportiert. Das Kühlmittel besitzt eine derartige Verdampfungstemperatur, dass im Betrieb die maximal zur Kühlung notwendige Lufttemperatur nicht überschritten wird.

Der zweite Kühlkreislauf 22 umfasst einen dritten Wärmeübertrager 24, der über eine Steigleitung 26 und eine Fallleitung 28 mit einem vierten Wärmeübertrager 30 verbunden ist. Der vierte Wärmeübertrager 30 ist außerhalb des Gehäuses 2 und vertikal oberhalb des dritten Wärmeübertragers 24 angeordnet. Die Steigleitung 26 und die Fallleitung 28 sind über Durchführungen 16 gegenüber dem Gehäuse 2 abgedichtet. Der interne dritte Wärmeübertrager 24 ist mit einem Ventilator 32 verbunden, der eine forcierte Luftströmung im Innern des Gehäuses 2 erzeugt, die durch Pfeile 21 charakterisiert ist.

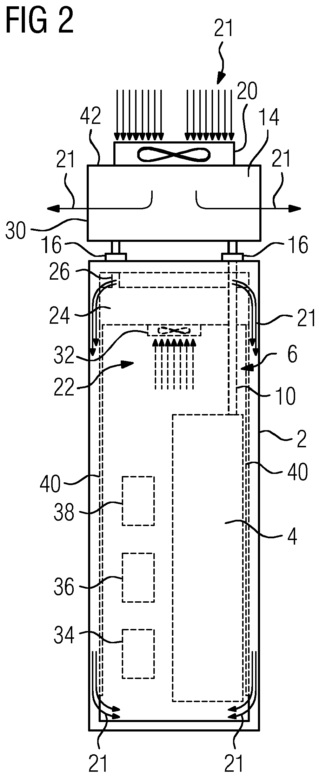

Der zweite Kühlkreislauf 22 dient der Entwärmung von weiteren im Innern des Gehäuses 2 angeordneten Betriebsmitteln, die nur eine geringe Verlustwärme abgeben und bei denen daher ein direkter Anschluss an einen Kühlkreislauf entbehrlich ist bzw. der Aufwand zum Anschluss an einen Kühlkreislauf in keinem vernünftigen Verhältnis zur abzuführenden Wärmemenge stünde. Dazu wird auf die in FIG 2 dargestellte Schnittzeichnung der Frontansicht des Frequenzumrichters Bezug genommen. Die Verlustwärme im Betrieb der weiteren Betriebsmittel besitzt eine niedrigere Verlustleistungsdichte als die Verlustleistungsdichte des Halbleitermoduls 4, so dass eine ausreichende Entwärmung über die forcierte Luftströmung erfolgen kann. Beispielhaft für die weiteren Betriebsmittel sind in FIG 2 ein Transformator 34, eine Kondensatorbaugruppe 36, eine Schalterbaugruppe 38 gezeigt. Es können jedoch weitere Betriebsmittel, die im Betrieb Wärme erzeugen, in das Gehäuse 2 eingebaut sein, beispielsweise Drosseln, Stromschienen, usw.

Um die Luftströmung an allen zu entwärmenden Betriebsmitteln entlang zu führen, ist eine Luftführung 40 vorgesehen. Die Luftführung 40 bildet Luftkanäle, in denen die entwärmte Luftströmung aus dem Bereich oberhalb des dritten Wärmeübertragers 24 in den unteren Bereich des Gehäuses 2 geführt ist. Die Luftströmung wird dabei durch die Luftführung 40 Seitenwänden des Gehäuses 2 nach unten geführt. Sie tritt im unteren Bereich des Gehäuses 2 wieder in den Innenraum des Gehäuses 2 ein. Auf dem Weg nach oben strömt die Luft im Innern des Gehäuses frei ohne weitere Luftführungselemente oder mit zusätzlichen Luftführungen (nicht dargestellt) und nimmt dabei die Verlustwärme der weiteren Betriebsmittel 34, 36, 38 auf. Die erwärmte Luft gibt dann ihre aufgenommene Wärme im dritten Wärmeübertrager 24 als Verdampfungswärme des Kühlmittels wieder ab.

Die externen Wärmeübertrager 14 und 30 des ersten und zweiten Kühlkreislaufs 6 und 22 sind vorzugsweise als bauliche Einheit in einem gemeinsamen Gehäuse 42 angeordnet. Der Ventilator 18 erzeugt in den beiden Wärmeübertragern 14 und 30 einen Luftstrom, über den die in den Kühlmitteln transportierte latente Wärme an die durchströmende Luft als Außenkühlmedium abgegeben wird.

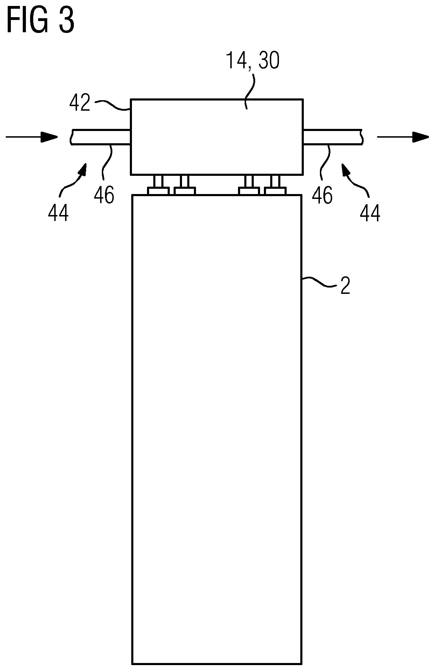

Eine alternative Ausführung der externen Wärmeübertrager 14, 30 zeigt schematisch FIG 3. Bei dieser Ausführungsform wird als Außenkühlmittel Wasser verwendet, welches von einem geschlossenen externen Wasser-Kühlkreislauf 44 geliefert wird. In FIG 3 sind nur eine Zufluss- und eine Abflussleitung 46 des externen Wasser-Kühlkreislaufs 44 zu den Wärmeübertragern 14, 30 gezeigt. Eine derartige Realisierung der Außenkühlung bietet sich an, wenn am Aufstellungsort schon ein Wasserkühlkreislauf für weitere zu kühlende Anlagenteile oder Betriebseinheiten existiert.

Die vorliegende Erfindung weist viele Vorteile auf. Insbesondere kann auf einfache und robuste Weise eine Kühlung von im Inneren von Gehäusen hoher Schutzart angeordneten, große Verlustleistungen erzeugenden elektrischen und elektronischen Betriebsmitteln erreicht werden.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Schaltschrank mit einem geschlossenen Gehäuse (2) und einer Kühlvorrichtung zum Kühlen von im Innern des Gehäuses (2) anordenbaren elektrischen und/oder elektronischen Betriebsmitteln (4,34,36,38) mit einem ersten geschlossenen Kühlkreislauf (6), der ein erstes Kühlmedium enthält zum Abtransport von Wärme, die im Betrieb von mindestens einem der Betriebsmittel (4) erzeugt wird, aus dem Gehäuse (2) heraus, wobei der erste Kühlkreislauf (6) innerhalb des Gehäuses (2) mit einem ersten Wärmeübertrager (8) zum Übertragen der Wärme von dem mindestens einen Betriebsmittel (4) auf das erste Kühlmedium und außerhalb des Gehäuses (2) mit einem zweiten Wärmeübertrager (14) zum Abgeben der Wärme an ein Außenkühlmedium verbunden ist, wobei der zweite Wärmeübertrager (14) oberhalb des ersten Wärmeübertragers (8) angeordnet ist, wobei der erste Kühlkreislauf (6), das erste Kühlmedium und der erste und zweite Wärmeübertrager (8,14) ausgebildet sind, den Wärmetransport nach dem Zweiphasen-Thermosiphon-Prinzip zu realisieren, und wobei der erste Kühlkreislauf (6) Leitungen (10,12) für das erste Kühlmedium umfasst, die über Durchführungen (16) abgedichtet aus dem Gehäuse (2) geführt sind und den ersten Wärmeübertrager (8) und den zweiten Wärmeübertrager (14) miteinander verbinden.

2. Schaltschrank nach Anspruch 1, **dadurch gekennzeichnet, dass** der erste Wärmeübertrager (8) als Kühlkörper (18) ausgebildet ist zur wärmeleitenden Verbindung mit dem mindestens einen der Betriebsmittel (4).

3. Schaltschrank nach Anspruch 1 oder 2, **dadurch gekennzeichnet , dass** der erste Wärmeübertrager (8) zur Montage mindestens eines Leistungshalbleiters ausgebildet ist.

4. Schaltschrank nach einem der vorstehenden Ansprüche, **dadurch gekennzeichnet, dass** der zweite Wärmeübertrager (14) einen Ventilator (20) umfasst und ausgebildet ist, die transportierte Wärme an Luft als Außenkühlmedium abzugeben.

5. Schaltschrank nach einem der Ansprüche 1 bis 3, **dadurch gekennzeichnet , dass** der zweite Wärmeübertrager (14) ausgebildet ist, die transportierte Wärme an einen geschlossenen Außenkühlkreislauf (44) abzugeben.

6. Schaltschrank nach einem der vorstehenden Ansprüche, mit einem zweiten geschlossenen Kühlkreislauf (22) zum Kühlen von mindestens einem weiteren, im Innern des geschlossenen Gehäuses (2) anordenbaren elektrischen und/oder elektronischen Betriebsmittel (34,36,38), der ein zweites Kühlmedium enthält zum Abtransport von Wärme, die im Betrieb von dem mindestens einem weiteren der Betriebsmittel (34,36,38) erzeugt wird, aus dem Gehäuse (2) heraus, wobei der zweite Kühlkreislauf (22) innerhalb des Gehäuses (2) mit einem dritten Wärmeübertrager (24) zum Übertragen der Wärme von dem mindestens einen weiteren Bauteil (34,36,38) auf das zweite Kühlmedium und au-βerhalb des Gehäuses (2) mit einem vierten Wärmeübertrager (30) zum Abgeben der Wärme an das Außenkühlmedium verbunden ist, dass der vierte Wärmeübertrager (30) oberhalb des dritten Wärmeübertragers (24) angeordnet ist und der zweite Kühlkreislauf (22), das zweite Kühlmedium und der dritte und vierte Wärmeübertrager (24,30) ausgebildet sind, den Wärmetransport nach dem Zweiphasen-Thermosiphon-Prinzip zu realisieren.

7. Schaltschrank nach Anspruch 6, **dadurch gekennzeichnet, dass** der dritte Wärmeübertrager (24) ausgebildet ist, die mittels einer Luftströmung von dem mindestens einen weiteren Betriebsmittel (34,36,38) zum dritten Wärmeübertrager (24) transportierte Wärme an das zweite Kühlmedium zu übertragen.

8. Schaltschrank nach Anspruch 6 oder 7, **dadurch gekennzeichnet , dass** der dritte Wärmeübertrager (24) einen Ventilator (32) umfasst.

9. Schaltschrank nach einem der Ansprüche 6 bis 8, **dadurch gekennzeichnet , dass** der dritte Wärmeübertrager (24) oberhalb des mindestens einen weiteren Betriebsmittels (34,36,38) angeordnet ist.

10. Schaltschrank nach einem der Ansprüche 6 bis 9, **dadurch gekennzeichnet, dass** der dritte Wärmeübertrager (24) im oberen Bereich des Gehäuses (2) angeordnet ist.

11. Schaltschrank nach einem der Ansprüche 6 bis 10, **dadurch gekennzeichnet, dass** der dritte Wärmeübertrager (24) mit einer im Gehäuse (2) angeordneten Luftführung (40) verbunden ist.

12. Schaltschrank nach Anspruch 6 bis 11, **dadurch gekennzeichnet , dass** der zweite und vierte Wärmeübertrager (14,30) eine bauliche Einheit (42) bilden zur Abgabe der transportierten Wärme an ein gemeinsames Kühlmedium.

## Claims

1. Switchgear cabinet comprising a closed housing (2) and a cooling device for cooling items of electrical and/or electronic equipment (4,34,36,38) that can be disposed inside the housing (2), comprising a first closed cooling circuit (6) containing a first cooling medium for removing heat generated during operation of at least one of the items of equipment (4) from the housing (2), wherein the first cooling circuit (6) is connected inside the housing (2) to a first heat exchanger (8) for transferring the heat from the at least one item of equipment (4) to the first cooling medium and, outside the housing (2), to a second heat exchanger (14) for dissipating the heat to an external cooling medium, wherein the second heat exchanger (14) is disposed above the first heat exchanger (8) and wherein the first cooling circuit (6), the first cooling medium and the first and second heat exchanger (8,14) are designed to implement heat transfer according to the two-phase thermosiphon principle, and wherein the first cooling circuit (6) comprises pipes (10,12) for the first cooling medium which extend out of the housing (2) in a sealed manner via feedthroughs (16) and interconnect the first heat exchanger (8) and the second heat exchanger (14).

2. Switchgear cabinet according to claim 1, **characterised in that** the first heat exchanger (8) is implemented as a heat sink (18) for thermally conductive connection to the at least one of the items of equipment (4).

3. Switchgear cabinet according to claim 1 or 2, **characterised in that** the first heat exchanger (8) is designed for mounting of least one power semiconductor.

4. Switchgear cabinet according to one of the preceding claims, **characterised in that** the second heat exchanger (14) comprises a fan (20) and is designed to dissipate the transferred heat to air as the external cooling medium.

5. Switchgear cabinet according to one of claims 1 to 3, **characterised in that** the second heat exchanger (14) is designed to dissipate the transferred heat to a closed external cooling circuit (44).

6. Switchgear cabinet according to one of the preceding claims, comprising a second closed cooling circuit (22) for cooling at least one other item of electrical and/or electronic equipment (34,36,38) that can be disposed inside the closed housing (2), said cooling circuit containing a second cooling medium for removing heat generated during operation of the at least one other of the items of equipment (34,36,38) from the housing (2), wherein the second cooling circuit (22) is connected inside the housing (2) to a third heat exchanger (24) for transferring the heat from the at least one other component (34,36,38) to the second cooling medium and, outside the housing (2), to a fourth heat exchanger (30) for dissipating the heat to the external cooling medium, that the fourth heat exchanger (30) is disposed above the third heat exchanger (24) and the second cooling circuit (22), the second cooling medium and the third and fourth heat exchanger (24,30) are designed to implement heat transfer according to the two-phase thermosiphon principle.

7. Switchgear cabinet according to claim 6, **characterised in that** the third heat exchanger (24) is designed to transfer, to the second cooling medium, the heat transported by means of an air flow from the at least one other item of equipment (34,36,38) to the third heat exchanger (24).

8. Switchgear cabinet according to claim 6 or 7, **characterised in that** the third heat exchanger (24) comprises a fan (32).

9. Switchgear cabinet according to one of claims 6 to 8, **characterised in that** the third heat exchanger (24) is disposed above the at least one other item of equipment (34, 36, 38) .

10. Switchgear cabinet according to one of claims 6 to 9, **characterised in that** the third heat exchanger (24) is disposed in the upper region of the housing (2).

11. Switchgear cabinet according to one of claims 6 to 10, **characterised in that** the third heat exchanger (24) is connected to an air duct (40) disposed in the housing (2).

12. Switchgear cabinet according to claim 6 to 11, **characterised in that** the second and fourth heat exchanger (14, 30) constitute a physical unit (42) for dissipating the transferred heat to a common cooling medium.

## Revendications

1. Armoire de distribution, comprenant une enveloppe (2) fermée et un dispositif de refroidissement pour refroidir des moyens (4, 34, 36, 38) électroniques et/ou électriques de fonctionnement pouvant être mis à l'intérieur de l'enveloppe (2) par un premier circuit (6) de refroidissement fermé, qui contient un premier fluide réfrigérant pour évacuer de l'enveloppe (2) de la chaleur produite en fonctionnement par au moins l'un des moyens (4) de fonctionnement, le premier circuit (6) de refroidissement, communiquant, à l'intérieur de l'enveloppe (2), avec un premier échangeur de chaleur (8) pour transmettre de la chaleur d'au moins un moyen (4) de fonctionnement au premier fluide réfrigérant et à l'extérieur de l'enveloppe (2), avec un deuxième échangeur (14) de chaleur pour céder de la chaleur à un fluide réfrigérant extérieur, le deuxième échangeur (14) de chaleur étant disposé au dessus du premier échangeur (8) de chaleur, le premier circuit (6) de refroidissement, le premier fluide réfrigérant et le premier et le deuxième échangeurs (8, 14) de chaleur étant constitués pour réaliser le transport de chaleur suivant le principe du thermosiphon à deux phases et le premier circuit (6) de refroidissement comprenant des conduits (10, 12) pour le premier fluide réfrigérant, qui sortent de l'enveloppe (2) d'une manière étanche par des traversées (16) et qui communiquent entre eux par le premier échangeur (8) de chaleur et par le deuxième échangeur (14) de chaleur.

2. Armoire de distribution suivant la revendication 1, **caractérisée en ce que** le premier échangeur (8) de chaleur est constitué en dissipateur (18) de chaleur pour une liaison conductrice de la chaleur avec le au moins un des moyens (4) de fonctionnement.

3. Armoire de distribution suivant la revendication 1 ou 2, **caractérisée en ce que** le premier échangeur (8) de chaleur est constitué pour le montage d'au moins un semi-conducteur de puissance.

4. Armoire de distribution suivant l'une des revendications précédentes, **caractérisée en ce que** le deuxième échangeur (14) de chaleur comprend un ventilateur (20), qui est constitué pour céder la chaleur transportée à de l'air, comme fluide réfrigérant extérieur.

5. Armoire de distribution suivant l'une des revendications 1 à 3, **caractérisée en ce que** le deuxième échangeur (14) de chaleur est constitué pour céder la chaleur transportée à un circuit (44) de refroidissement extérieur fermé.

6. Armoire de distribution suivant l'une des revendications précédentes, comprenant un deuxième circuit (22) de refroidissement fermé pour refroidir au moins un autre moyen (34, 36, 38) électrique et/ou électronique de fonctionnement pouvant être disposé à l'intérieur de l'enveloppe (2) fermée, circuit qui contient un deuxième fluide réfrigérant pour l'évacuation de l'enveloppe (2) de la chaleur produite en fonctionnement par le au moins un autre des moyens (34, 36, 38) de fonctionnement, le deuxième circuit (22) de refroidissement communiquant à l'intérieur de l'enveloppe (2) avec un troisième échangeur (24) de chaleur pour transmettre de la chaleur du au moins un autre composant (34, 36, 38) au deuxième fluide réfrigérant et à l'extérieur de l'enveloppe (2) avec un quatrième échangeur (30) de chaleur pour céder de la chaleur au fluide réfrigérant extérieur, en ce que le quatrième échangeur (30) de chaleur est disposé au dessus du troisième échangeur (34) de chaleur et le deuxième circuit (22) de refroidissement, le deuxième fluide réfrigérant et le troisième et le quatrième échangeurs (24, 30) de chaleur sont constitués pour réaliser le transport de chaleur suivant le principe du thermosiphon à deux phases.

7. Armoire de distribution suivant la revendication 6, **caractérisée en ce que** le troisième échangeur (24) de chaleur est constitué pour transmettre au deuxième fluide de refroidissement la chaleur transportée, au moyen d'un écoulement d'air, du au moins un autre moyen (34, 36, 38) de fonctionnement au troisième échangeur (24) de chaleur.

8. Armoire de distribution suivant la revendication 6 ou 7, **caractérisée en ce que** le troisième échangeur (24) de chaleur comprend un ventilateur (32).

9. Armoire de distribution suivant l'une des revendication 6 à 8, **caractérisée en ce que** le troisième échangeur (24) de chaleur est disposé au dessus du au moins un autre moyen (34, 36, 38) de fonctionnement.

10. Armoire de distribution suivant l'une des revendications 6 à 9, **caractérisée en ce que** le troisième échangeur (24) de chaleur est disposé dans la partie supérieure de l'enveloppe (2).

11. Armoire de distribution suivant l'une des revendications 6 à 10, **caractérisée en ce que** le troisième échangeur (24) de chaleur communique avec un conduit (40) d'air disposé dans l'enveloppe (2).

12. Armoire de distribution suivant la revendication 6 à 11, **caractérisée en ce que** le deuxième et le quatrième échangeurs (14, 30) de chaleur forme une unité (42) de construction pour céder la chaleur transportée à un fluide réfrigérant commun.
